# EUROPEAN PATENT APPLICATION

(11) **EP 1 600 815 A2**
(43) Date of publication of application: **30.11.2005**
(21) Application number: 05009722.9
(22) Date of filing: 03.05.2005
(51) Int. Cl.: G03F 7/20

(54) **Semiconductor manufacturing apparatus and pattern formation method**

(30) Priority: 17.05.2004 JP 2004146219
(71) Applicant: MATSUSHITA ELECTRIC INDUSTRIAL CO., LTD., Kadoma-shi, Osaka 571-8501 (JP)
(72) Inventor: Endo, Masayuki, Kishiwada-shi Osaka 596-0825 (JP); Sasago, Masaru, Hirakata-shi Osaka 573-0007 (JP)
(74) Representative: Grünecker, Kinkeldey, Stockmair & Schwanhäusser Anwaltssozietät

(57) **Abstract**

A semiconductor manufacturing apparatus includes a liquid supplying section for supplying a liquid to be provided on a stage where a substrate having a resist film is placed; an exposing section for irradiating the resist film with exposing light through a mask with the liquid provided on the resist film on the stage; and an ionization preventing section for preventing ionization of the liquid.

## Description

### CROSS-REFERENCE TO RELATED APLICATIONS

This application claims priority under 35 U.S.C. §119 on Patent Application No. 2004-146219 filed in Japan on May 17, 2004, the entire contents of which are hereby incorporated by reference.

### BACKGROUND OF THE INVENTION

The present invention relates to a semiconductor manufacturing apparatus for use in fabrication process or the like for semiconductor devices and a pattern formation method using the same.

In accordance with the increased degree of integration of semiconductor integrated circuits and downsizing of semiconductor devices, there are increasing demands for further rapid development of lithography technique. Currently, pattern formation is carried out through photolithography using exposing light of a mercury lamp, KrF excimer laser, ArF excimer laser or the like, and use of F₂ laser lasing at a shorter wavelength is being examined. However, since there remain a large number of problems in exposure systems and resist materials, photolithography using exposing light of a shorter wavelength has not been put to practical use.

In these circumstances, immersion lithography has been recently proposed for realizing further refinement of patterns by using conventional exposing light (for example, see M. Switkes and M. Rothschild, "Immersion lithography at 157 nm", J. Vac. Sci. Technol., Vol. B19, p. 2353 (2001)).

In the immersion lithography, a region in an exposure system sandwiched between a projection lens and a resist film formed on a wafer is filled with a liquid having a refractive index **n** (whereas n > 1) and therefore, the NA (numerical aperture) of the exposure system has a value **n·NA.** As a result, the resolution of the resist film can be improved.

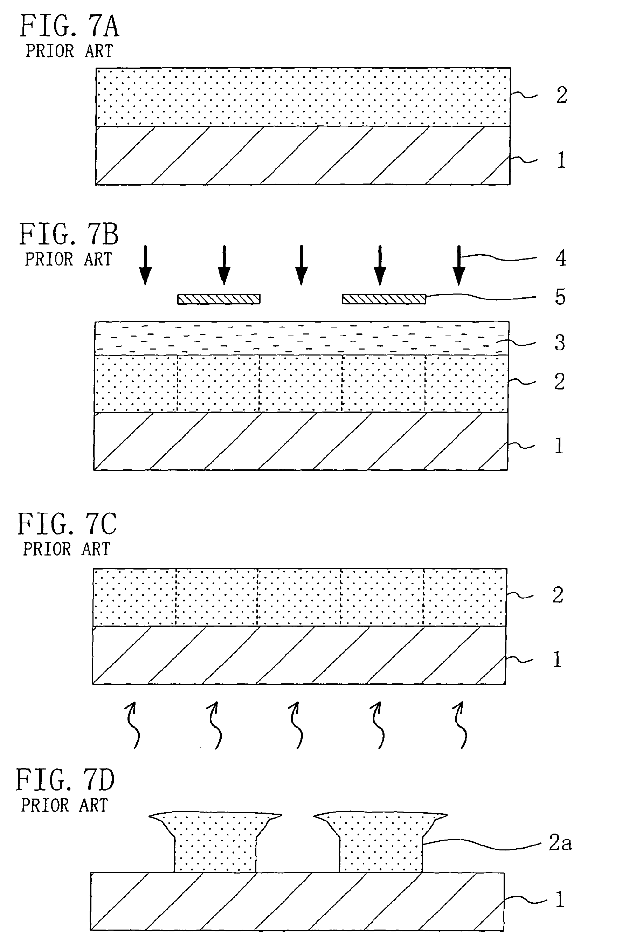

Now, a conventional pattern formation method employing the immersion lithography will be described with reference to FIGS. **7A** through **7D.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium triflate | 0.04 g |
| Quencher: triethanolamine | 0.002 g |
| Solvent: propylene glycol monomethyl ether acetate | 20 g |

Next, as shown in FIG. **7A,** the aforementioned chemically amplified resist material is applied on a substrate **1** so as to form a resist film **2** with a thickness of 0.35 µm.

Then, as shown in FIG. **7B,** with water **3** provided on the resist film **2,** pattern exposure is carried out by irradiating the resist film **2** with exposing light **4** of ArF excimer laser with NA of 0.68 through a mask **5.**

After the pattern exposure, as shown in FIG. **7C,** the resist film **2** is baked with a hot plate at a temperature of 105°C for 60 seconds, and the resultant resist film is developed with a 2.38 wt% tetramethylammonium hydroxide developer. In this manner, a resist pattern **2a** made of an unexposed portion of the resist film **2** and having a line width of 0.09 µm is formed as shown in FIG. **7D.**

### SUMMARY OF THE INVENTION

As shown in FIG **7D,** however, the resist pattern **2a** formed by the conventional pattern formation method is in a defective shape.

The present inventors have variously examined the reason why the resist pattern formed by the conventional immersion lithography is in a defective shape, resulting in finding the following: The resist film cannot exhibit its expected performance because a low-molecular-weight compound such as the acid generator or the quencher is eluted from the resist film **2** into the water **3** provided on the resist film **2** or because the water **3** permeates into the resist film **2.** For example, in the case shown in FIG. **7D,** the resist pattern **2a** is in a defective shape with a T-top shaped portion probably because the concentration of the acid generator is lowered on the interface between an exposed portion and the unexposed portion of the resist film 2. On the contrary, when the concentration of the quencher used for deactivating the acid generator is lowered, the resultant resist pattern **2a** is in a defective shape with round shoulders.

In either case, when the resist pattern **2a** in such a defective shape is used for etching a target film, the resultant pattern of the target film is also in a defective shape, which disadvantageously lowers the productivity and the yield in the fabrication process for semiconductor devices.

In consideration of the aforementioned conventional problem, an object of the invention is forming a fine resist pattern in a good shape by preventing the influence of a liquid used in the immersion lithography on a resist film.

The present inventors have found, on the basis of the aforementioned result of the examination, that elution into a liquid of a low-molecular-weight component such as an acid generator or a quencher included in a resist and permeation of a liquid into a resist can be prevented by preventing ionization of the liquid provided on the resist film in exposure for increasing the numerical aperture of exposing light. On the contrary, when the liquid has ionicity, compatibility between the liquid and the acid generator or the quencher is large and hence the elution from the resist into the liquid is increased, and also, compatibility between the liquid and a polarity portion such as a polymer of the resist is large and hence the permeation of the liquid into the resist is increased.

The present invention was devised on the basis of the aforementioned findings, and according to the invention, the ionization of a liquid provided on a resist film is prevented, so that the resist film can keep its expected performance. Specifically, the present invention is practiced as follows:

The semiconductor manufacturing apparatus of this invention includes a liquid supplying section for supplying a liquid to be provided on a stage where a substrate having a resist film is placed; an exposing section for irradiating the resist film with exposing light through a mask with the liquid provided on the resist film on the stage; and an ionization preventing section for preventing ionization of the liquid.

In the semiconductor manufacturing apparatus of this invention, ionization of the liquid provided on the resist film can be prevented, and therefore, elution of a low-molecular-weight component of the resist film into the liquid and permeation of the liquid into the resist film can be prevented in the exposure. Accordingly, influence of the liquid used for the immersion lithography on the resist can be prevented, so as to keep the expected performance of the resist. As a result, a fine pattern can be formed in a good shape.

In the semiconductor manufacturing apparatus of this invention, the ionization preventing section preferably includes an inert gas supplying section for providing an inert gas atmosphere at least in the vicinity of the liquid provided on the stage. When the liquid is thus put in the inert gas atmosphere, the liquid never comes into direct contact with the air, and hence, a carbon dioxide gas (CO₂) does not dissolve in the liquid. Accordingly, the liquid can be prevented from being ionized by carbonic acid (H₂CO₃) generated from a carbon dioxide gas dissolved in the liquid.

In the semiconductor manufacturing apparatus of this invention, the ionization preventing section preferably includes a decarbonating section for removing a carbon dioxide gas from an atmosphere at least in the vicinity of the liquid provided on the stage. When a carbon dioxide gas is thus removed from the atmosphere at least in the vicinity of the liquid provided on the stage, even if the liquid comes into contact with the air, the liquid can be prevented from being ionized by carbonic acid generated from a carbon dioxide gas dissolved in the liquid because the carbon dioxide gas included in the air is removed.

In the semiconductor manufacturing apparatus of this invention, the ionization preventing section preferably includes an ultrapure water generating section for receiving the liquid from the liquid supplying section and changing the liquid into ultrapure water. When the liquid provided on the stage is thus sufficiently deionized, the deionized liquid is minimally ionized even if it comes into contact with the air.

In this case, the ionization preventing section preferably sets conductivity of the liquid to 0.03 µS/cm or less.

In the case where the semiconductor manufacturing apparatus of this invention includes the inert gas supplying section, the inert gas atmosphere may include at least one of nitrogen, argon and neon.

In the case where the semiconductor manufacturing apparatus of this invention includes the decarbonating section, the decarbonating section may be hydrotalcite. It is noted that hydrotalcite is a compound having a layered structure with a typical composition of Mg₆Al₂(OH)₁₆·O₃·H₂O.

The first pattern formation method of this invention, which is employed in a semiconductor manufacturing apparatus including a stage for placing a substrate having a resist film and an exposing section for irradiating the resist film with exposing light through a mask with a liquid provided on the resist film on the stage, includes the steps of forming the resist film on the substrate; obtaining an atmosphere in which the liquid is minimally ionized at least in the vicinity of the resist film out of a region where the liquid is provided; performing pattern exposure by selectively irradiating the resist film with the exposing light with the liquid provided on the resist film in the atmosphere; and forming a resist pattern by developing the resist film after the pattern exposure.

In the first pattern formation method, since the atmosphere in which the liquid is minimally ionized is obtained at least in the vicinity of the resist film out of the region where the liquid is provided, the liquid provided on the resist film can be prevented from being ionized. Therefore, the elution of a low-molecular-weight component of the resist film into the liquid and the permeation of the liquid into the resist film can be prevented in the pattern exposure. As a result, the influence of the liquid used for the immersion lithography on the resist can be prevented, so as to keep the expected performance of the resist. Thus, a fine pattern can be formed in a good shape.

In the first pattern formation method, the step of obtaining an atmosphere in which the liquid is minimally ionized preferably includes a sub-step of supplying an inert gas to above the resist film. When the liquid is thus exposed to the inert gas in the exposure, the liquid never comes into contact with the air and hence a carbon dioxide gas included in the air does not dissolve in the liquid. Accordingly, the liquid can be prevented from being ionized by carbonic acid.

In the first pattern formation method, the step of obtaining an atmosphere in which the liquid is minimally ionized preferably includes a sub-step of providing an atmosphere of an inert gas above the resist film.

In the first pattern formation method, the step of obtaining an atmosphere in which the liquid is minimally ionized preferably includes a sub-step of allowing an inert gas to flow above the resist film.

In the first pattern formation method, the step of obtaining an atmosphere in which the liquid is minimally ionized preferably includes a sub-step of removing a carbon dioxide gas from an atmosphere above the resist film. When a carbon dioxide gas is thus removed from the atmosphere above the resist film, even if the liquid comes into contact with the air, a carbon dioxide gas does not dissolve in the liquid. Accordingly, the liquid can be prevented from being ionized by carbonic acid.

The second pattern formation method of this invention includes the steps of forming a resist film on a substrate; providing, onto the resist film, a liquid having been prevented from being ionized; performing pattern exposure by selectively irradiating the resist film with exposing light with the liquid having been prevented from being ionized provided on the resist film; and forming a resist pattern by developing the resist film after the pattern exposure.

In the second pattern formation method, the liquid having been prevented from being ionized is provided on the resist film, and therefore, the liquid having been prevented from being ionized is minimally ionized even when it comes into contact with the air. Accordingly, the elution of a low-molecular-weight component of the resist film into the liquid and the permeation of the liquid into the resist film can be prevented in the pattern exposure. As a result, the influence of the liquid used for the immersion lithography on the resist can be prevented, so as to keep the expected performance of the resist. Thus, a fine pattern can be formed in a good shape.

In the second pattern formation method, the step of providing a liquid having been prevented from being ionized preferably includes a sub-step of changing the liquid into ultrapure water.

In the second pattern formation method, the liquid having been prevented from being ionized preferably has conductivity of 0.03 µS/cm or less.

In the first pattern formation method, when the inert gas is used, the inert gas may be at least one of nitrogen, argon and neon.

In the first pattern formation method, when the carbon dioxide gas is removed, hydrotalcite may be used for removing the carbon dioxide gas.

In the semiconductor manufacturing apparatus and the pattern formation methods of this invention, the liquid used for increasing the value of numerical aperture of the exposing light may be water or perfluoropolyether.

In the semiconductor manufacturing apparatus and the pattern formation methods of this invention, the exposing light may be KrF excimer laser, ArF excimer laser, F₂ laser, Kr₂ laser, ArKr laser, Ar₂ laser or Xe₂ laser.

### BRIEF DESCRIPTION OF THE DRAWINGS

FIG. **1** is a cross-sectional view of a principal part of a semiconductor manufacturing apparatus according to Embodiment 1 of the invention;
FIGS. **2A, 2B, 2C** and **2D** are cross-sectional views for showing procedures in a pattern formation method using the semiconductor manufacturing apparatus of Embodiment 1 of the invention;
FIG. **3** is a cross-sectional view of a principal part of a semiconductor manufacturing apparatus according to Embodiment 2 of the invention;
FIGS. **4A, 4B, 4C** and **4D** are cross-sectional views for showing procedures in a pattern formation method using the semiconductor manufacturing apparatus of Embodiment 2 of the invention;
FIG. **5** is a cross-sectional view of a principal part of a semiconductor manufacturing apparatus according to Embodiment 3 of the invention;
FIGS. **6A, 6B, 6C** and **6D** are cross-sectional views for showing procedures in a pattern formation method using the semiconductor manufacturing apparatus of Embodiment 3 of the invention; and
FIGS. **7A, 7B, 7C** and **7D** are cross-sectional views for showing procedures in a conventional pattern formation method.

### DETAILED DESCRIPTION OF THE INVENTION

### EMBODIMENT 1

Embodiment 1 of the invention will now be described with reference to the accompanying drawings.

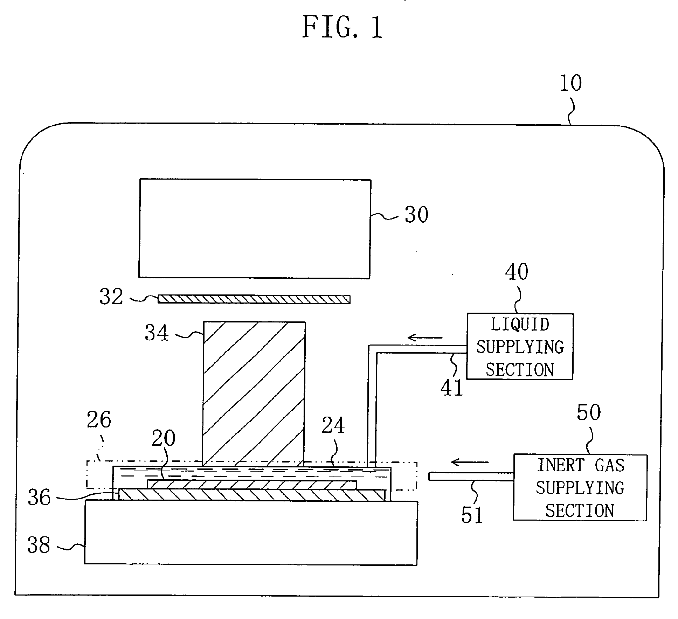

FIG. **1** schematically shows the cross-sectional structure of a principal part of a semiconductor manufacturing apparatus used for realizing a pattern formation method employing the immersion lithography according to Embodiment 1 of the invention.

As shown in FIG. **1,** the semiconductor manufacturing apparatus of Embodiment 1 includes an optical system **30** provided within a chamber **10** and working as a light source for exposing a design pattern on a resist film (not shown) applied on a principal face of a wafer **20;** a liquid supplying section **40** for supplying, through a supply path **41,** a liquid **24** to be provided on the resist film of the wafer **20** in exposure for increasing the numerical aperture of exposing light; and an inert gas supplying section **50** that corresponds to an ionization preventing section and supplies an inert gas **26** of, for example, a nitrogen (N₂) gas from a supply port **51** onto the principal face of the wafer **20** for placing the inert gas **26** in a flow state.

Below the optical system **30** within the chamber **10,** an exposing section (projection lens) **34** for projecting, through a liquid **24** onto the resist film, the exposing light emitted from the optical system **30** and entering through a mask (reticle) **32** having the design pattern to be transferred onto the resist film and a movable stage **36** for holding the wafer **20** are disposed. The exposing section **34** is held to be in contact with the surface of the liquid **24** provided on the resist film of the wafer **20** so as to cover the movable stage **36** (or the wafer **20**) in the exposure. Also, the movable stage **36** is held on a surface plate **38** movably against the exposing section **34.**

It is noted that the inert gas **26** may be filled in the chamber **10** so as to obtain an inert gas atmosphere within the whole chamber **10** instead of always flowing in the vicinity of the movable stage **36.** Alternatively, an inert gas atmosphere may be provided merely in a region where the liquid **24** is possibly exposed to the air on the path for supplying it from the liquid supplying section **40** to above the movable stage **36.** Herein, the inert gas **26** may be argon (Ar) or neon (Ne) instead of nitrogen. Alternatively, a mixed gas including at least one of nitrogen, argon and neon may be used as the inert gas **26.**

Furthermore, a previously deionized liquid may be used as the liquid **24** supplied from the liquid supplying section **40** to above the movable stage **36.**

The liquid supplying section **40** and the inert gas supplying section **50** may be provided within or out of the chamber **10.**

In this manner, in the semiconductor manufacturing apparatus of Embodiment 1, the inert gas **26** is allowed to flow or an inert gas atmosphere is provided at least in the vicinity of the liquid **24** provided on the wafer **20** for increasing the value of a numerical aperture (NA), and therefore, the liquid **24** never comes into contact with the air. As a result, a carbon dioxide gas (CO₂) included in the air never dissolves in the liquid **24,** so that the liquid **24** can be preventing from being ionized by carbonic acid (H₂CO₃) generated when the carbon dioxide gas dissolves in the liquid **24.** In this manner, the influence of the liquid **24** on a resist can be prevented, and hence, the resist can keep its expected performance. As a result, a fine pattern can be formed in a good shape.

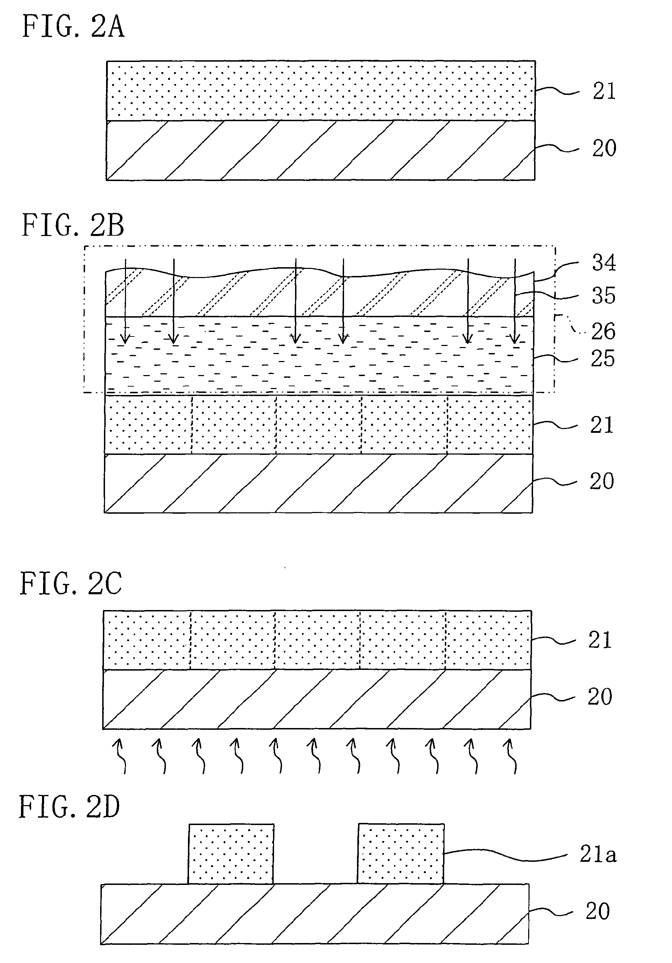

Now, a pattern formation method using the semiconductor manufacturing apparatus of FIG. **1** will be described with reference to FIGS. **2A** through **2D.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium triflate | 0.04 g |
| Quencher: triethanolamine | 0.002 g |
| Solvent: propylene glycol monomethyl ether acetate | 20 g |

Next, as shown in FIG. **2A,** the aforementioned chemically amplified resist material is applied on a substrate **20** so as to form a resist film **21** with a thickness of 0.35 µm.

Then, as shown in FIG. **2B,** with a liquid **24** of water provided between the resist film **21** and a projection lens **34,** pattern exposure is carried out by irradiating the.resist film **21** through a mask (not shown) with exposing light **35** of ArF excimer laser with NA of 0.68. At this point, as shown in FIG. **1,** the liquid **24** provided on the resist film **21** is exposed to the inert gas **26** supplied in a flow state from the supply port **51** of the inert gas supplying section **50** in the exposure.

After the pattern exposure, as shown in FIG. **2C,** the resist film **21** is baked with a hot plate at a temperature of 105°C for 60 seconds, and thereafter, the resultant resist film **21** is developed with a 2.38 wt% tetramethylammonium hydroxide developer. In this manner, a resist pattern **21a** made of an unexposed portion of the resist film **21** and having a line width of 0.09 µm is formed in a good shape as shown in FIG. **2D.**

In this manner, according to the pattern formation method of Embodiment 1, the liquid **24** provided on the resist film **21** is exposed to the inert gas **26** in the exposure, and hence, the liquid **24** never comes into direct contact with the air. Therefore, the liquid **24** can be prevented from being ionized by carbonic acid generated when a carbon dioxide gas included in the air dissolves in the liquid **24.** Accordingly, elution of a low-molecular-weight component such as the acid generator or the quencher included in the resist into the liquid and permeation of the liquid **24** into the resist can be prevented. As a result, the expected performance of the resist film **21** can be kept, so that the fine resist pattern **21a** can be formed in a good shape.

It is noted that the liquid **24** may be perfluoropolyether instead of water.

### EMBODIMENT 2

Embodiment 2 of the invention will now be described with reference to the accompanying drawings.

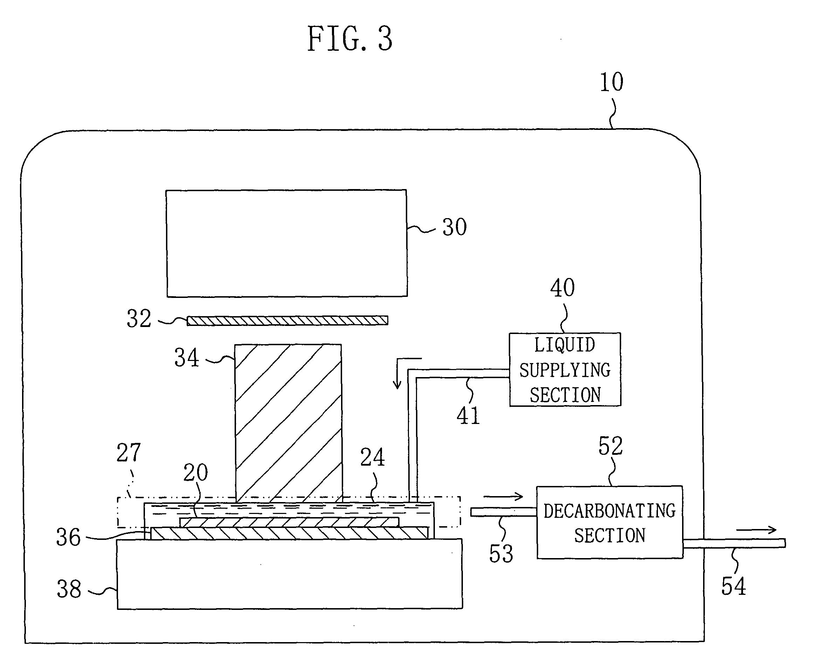

FIG. **3** schematically shows the cross-sectional structure of a principal part of a semiconductor manufacturing apparatus used for realizing a pattern formation method employing the immersion lithography according to Embodiment 2 of the invention. In FIG. **3,** like reference numerals are used to refer to like elements shown in FIG. **1** so as to omit the description.

As shown in FIG. **3,** the semiconductor manufacturing apparatus of Embodiment 2 includes a decarbonating section **52** that corresponds to an ionization preventing section, aspirates an atmosphere **27** present at least in the vicinity of a liquid **24** provided on a wafer **20** held on a movable stage **36** and adsorbs a carbon dioxide gas included in the aspirated atmosphere **27** with the rest of the atmosphere discharged.

The decarbonating section **52** has an aspiration port **53** opened on the side close to the movable stage **36** and a discharge port **54** for discharging to the outside of the chamber **10,** and removes a carbon dioxide gas from the atmosphere by using a known compound or the like capable of adsorbing carbon such as hydrotalcite. At this point, the atmosphere from which the carbon dioxide gas has been removed (i.e., the exhausted gas) may be discharged to the inside of a chamber **10.**

Furthermore, the decarbonating section **52** may remove a carbon dioxide gas not only from the vicinity of the movable stage **36** but also from the whole inside of the chamber **10** or from an atmosphere of a region where the liquid **24** is exposed to the air.

Also, a previously deionized liquid may be used as the liquid **24** supplied from a liquid supplying section **40** to above the movable stage **36.**

The liquid supplying section **40** and the decarbonating section **52** may be provided within or out of the chamber **10.** Alternatively, the liquid supplying section **40** alone may be provided outside the chamber **10.**

In this manner, in the semiconductor manufacturing apparatus of Embodiment 2, a carbon dioxide gas is removed from the atmosphere **27** at least in the vicinity of the liquid **24** provided onto the wafer **20** for increasing the value of the numerical aperture (NA), and therefore, a carbon dioxide gas (CO₂) never dissolves in the liquid **24.** Accordingly, the liquid **24** can be preventing from being ionized by carbonic acid (H₂CO₃) generated when a carbon dioxide gas included in the atmosphere dissolves in the liquid **24,** and hence the influence of the liquid **24** on a resist can be prevented. In this manner, the resist can keep its expected performance. As a result, a fine pattern can be formed in a good shape.

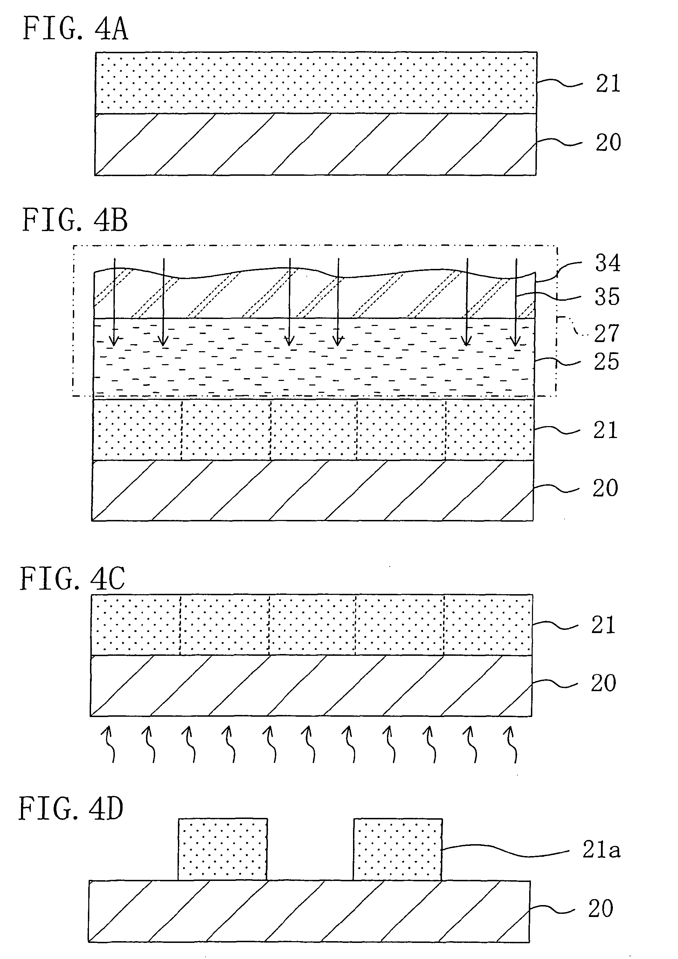

Now, a pattern formation method using the semiconductor manufacturing apparatus of FIG. **3** will be described with reference to FIGS. **4A** through **4D.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium triflate | 0.04 g |
| Quencher: triethanolamine | 0.002 g |
| Solvent: propylene glycol monomethyl ether acetate | 20 g |

Next, as shown in FIG. **4A,** the aforementioned chemically amplified resist material is applied on a substrate **20** so as to form a resist film **21** with a thickness of 0.35 µm.

Then, as shown in FIG. **4B,** with a liquid **24** of water provided between the resist film **21** and a projection lens **34,** pattern exposure is carried out by irradiating the resist film **21** through a mask (not shown) with exposing light **35** of ArF excimer laser with NA of 0.68. At this point, as shown in FIG. **3,** the atmosphere **27** covering the liquid **24** provided on the resist film **21** is aspirated from the aspiration port **53** of the decarbonating section 52 during the exposure for removing a carbon dioxide gas from the atmosphere **27.**

After the pattern exposure, as shown in FIG. **4C,** the resist film **21** is baked with a hot plate at a temperature of 105°C for 60 seconds, and thereafter, the resultant resist film **21** is developed with a 2.38 wt% tetramethylammonium hydroxide developer. In this manner, a resist pattern **21a** made of an unexposed portion of the resist film **21** and having a line width of 0.09 µm is formed in a good shape as shown in FIG. **4D.**

In this manner, according to the pattern formation method of Embodiment 2, a carbon dioxide gas included in the atmosphere **27** covering the liquid **24** provided on the resist film **21** is removed in the exposure, and hence, the liquid **24** never comes into contact with a carbon dioxide gas. Therefore, the liquid **24** can be prevented from being ionized by carbonic acid generated when a carbon dioxide gas included in the atmosphere **27** dissolves in the liquid **24.** Accordingly, the elution of a low-molecular-weight component such as the acid generator or the quencher included in the resist into the liquid and the permeation of the liquid **24** into the resist can be prevented. As a result, the expected performance of the resist film **21** can be kept, so that the fine resist pattern **21a** can be formed in a good shape.

It is noted that the liquid **24** may be perfluoropolyether instead of water.

### EMBODIMENT 3

Embodiment 3 of the invention will now be described with reference to the accompanying drawings.

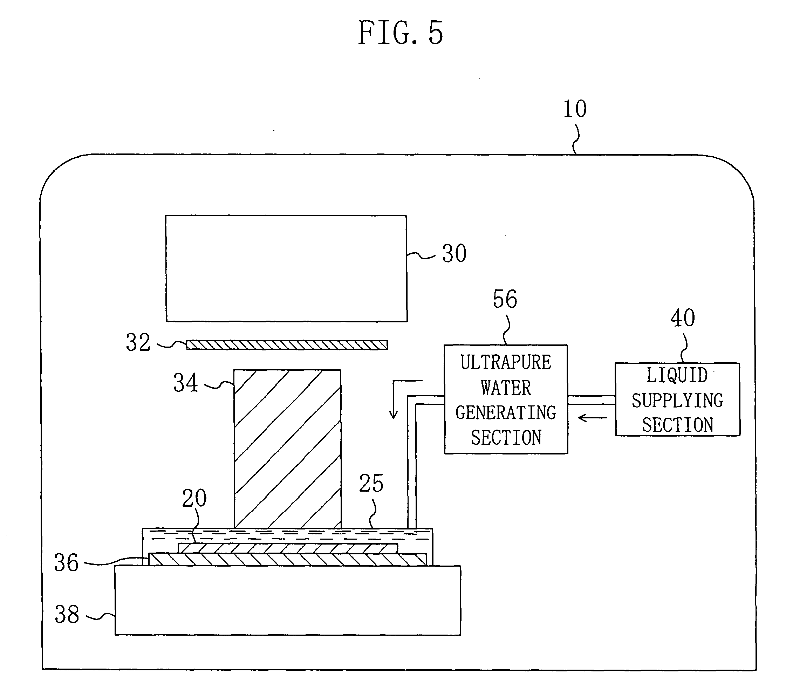

FIG. **5** schematically shows the cross-sectional structure of a principal part of a semiconductor manufacturing apparatus used for realizing a pattern formation method employing the immersion lithography according to Embodiment 3 of the invention. In FIG. **5,** like reference numerals are used to refer to like elements shown in FIG. **1** so as to omit the description.

As shown in FIG. **5,** the semiconductor manufacturing apparatus of Embodiment 3 includes an ultrapure water generating section **56** that corresponds to an ionization preventing section, receives a liquid supplied from a liquid supplying section **40** for generating ultrapure water and supplies the generated ultrapure water to above a movable stage **36.**

As the ultrapure water generating section **56,** any known apparatus for obtaining pure or ultrapure water may be used. Herein, the ultrapure water is generated so as to have conductivity of 0.06 µS/cm or less and more preferably of 0.03 µS/cm or less.

As a modification of this embodiment, ultrapure water may be directly supplied to the liquid supplying section **40.** In this case, the ultrapure water generating section **56** is unnecessary.

The liquid supplying section **40** and the ultrapure water supplying section **56** may be provided within or out of the chamber **10.**

In this manner, in the semiconductor manufacturing apparatus of Embodiment 3, a liquid **25** provided onto a wafer **20** for increasing the value of the numerical aperture (NA) is deionized to be changed into ultrapure water, and therefore, the deionized water is minimally ionized even when it comes to contact with the atmosphere. As a result, a carbon dioxide gas (CO₂) minimally dissolves in the liquid **25,** so that the liquid **25** can be preventing from being ionized by carbonic acid (H₂CO₃) generated when a carbon dioxide gas dissolves in the liquid **25.** In this manner, the influence of the liquid **25** on a resist can be prevented, and hence, the resist can keep its expected performance. As a result, a fine pattern can be formed in a good shape.

Now, a pattern formation method using the semiconductor manufacturing apparatus of FIG. **5** will be described with reference to FIGS. **6A** through **6D.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium triflate | 0.04 g |
| Quencher: triethanolamine | 0.002 g |
| Solvent: propylene glycol monomethyl ether acetate | 20 g |

Next, as shown in FIG. **6A,** the aforementioned chemically amplified resist material is applied on a substrate **20** so as to form a resist film **21** with a thickness of 0.35 µm.

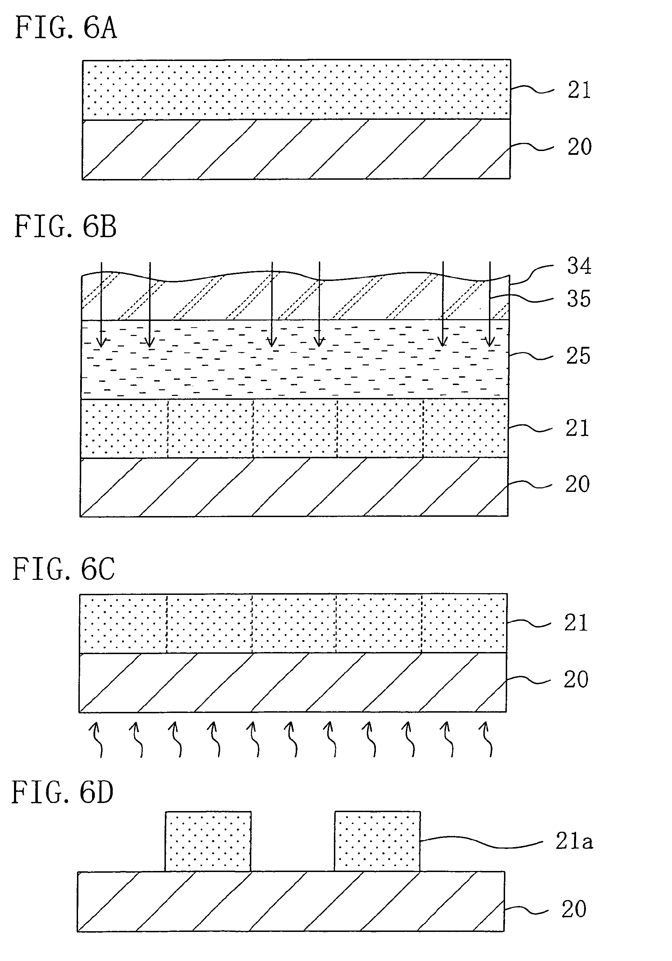

Then, as shown in FIG. **6B,** with a liquid **25** of water with conductivity of 0.025 µS/cm provided between the resist film **21** and a projection lens **34,** pattern exposure is carried out by irradiating the resist film **21** through a mask (not shown) with exposing light **35** of ArF excimer laser with NA of 0.68.

After the pattern exposure, as shown in FIG. **6C,** the resist film **21** is baked with a hot plate at a temperature of 105°C for 60 seconds, and thereafter, the resultant resist film **21** is developed with a 2.38 wt% tetramethylammonium hydroxide developer. In this manner, a resist pattern **21a** made of an unexposed portion of the resist film **21** and having a line width of 0.09 µm is formed in a good shape as shown in FIG. **6D.**

In this manner, according to the pattern formation method of Embodiment 3, the liquid **25** provided on the resist film **21** in the pattern exposure is ultrapure water used for deionization, and hence, even when the liquid **25** comes in contact with the atmosphere, a carbon dioxide gas included in the air minimally dissolves in the liquid. Therefore, the liquid **25** can be prevented from being ionized by carbonic acid. Accordingly, the elution of a low-molecular-weight component such as the acid generator or the quencher included in the resist into the liquid and the permeation of the liquid **25** into the resist can be prevented. As a result, the expected performance of the resist film **21** can be kept, so that the fine resist pattern **21a** can be formed in a good shape.

Although the liquid **24** or **25** used for increasing the value of the numerical aperture of the exposing light 35 is supplied to above the movable stage **36** (the wafer **20)** by a pooling method in each of Embodiments 1 through 3, a dropping method in which the liquid **24** or **25** is locally provided between the wafer **20** and the projection lens **34** in the form of drops may be employed instead.

Moreover, although ArF excimer laser is used as the exposing light **35,** KrF excimer laser, F₂ laser, Kr₂ laser, ArKr laser, Ar₂ laser or Xe₂ laser may be used instead.

As described so far, according to the semiconductor manufacturing apparatus and the pattern formation method using the same of this invention, ionization of a liquid used in the immersion lithography can be prevented and hence abnormal exposure derived from, for example, the elution of a resist component into the liquid can be prevented, so that a resist pattern can be formed in a good shape. Accordingly, the present invention is useful as a semiconductor manufacturing apparatus and a pattern formation method employing the immersion lithography.

## Claims

1. A semiconductor manufacturing apparatus comprising:
a liquid supplying section for supplying a liquid to be provided on a stage where a substrate having a resist film is placed;
an exposing section for irradiating said resist film with exposing light through a mask with said liquid provided on said resist film on said stage; and
an ionization preventing section for preventing ionization of said liquid.

2. The semiconductor manufacturing apparatus of Claim 1,
wherein said ionization preventing section includes an inert gas supplying section for providing an inert gas atmosphere at least in the vicinity of said liquid provided on said stage.

3. The semiconductor manufacturing apparatus of Claim 2,
wherein said inert gas atmosphere includes at least one of nitrogen, argon and neon.

4. The semiconductor manufacturing apparatus of Claim 1,
wherein said ionization preventing section includes a decarbonating section for removing a carbon dioxide gas from an atmosphere at least in the vicinity of said liquid provided on said stage.

5. The semiconductor manufacturing apparatus of Claim 4,
wherein said decarbonating section is hydrotalcite.

6. The semiconductor manufacturing apparatus of Claim 1,
wherein said ionization preventing section includes an ultrapure water generating section for receiving said liquid from said liquid supplying section and changing said liquid into ultrapure water.

7. The semiconductor manufacturing apparatus of Claim 1,
wherein said ionization preventing section sets conductivity of said liquid to 0.03 µS/cm or less.

8. The semiconductor manufacturing apparatus of Claim 1,
wherein said liquid is water or perfluoropolyether.

9. The semiconductor manufacturing apparatus of Claim 1,
wherein said exposing light is KrF excimer laser, ArF excimer laser, F₂ laser, Kr₂ laser, ArKr laser, Ar₂ laser or Xe₂ laser.

10. A pattern formation method, employed in a semiconductor manufacturing apparatus including a stage for placing a substrate having a resist film and an exposing section for irradiating said resist film with exposing light through a mask with a liquid provided on said resist film on said stage, comprising the steps of:
forming said resist film on said substrate;
obtaining an atmosphere in which said liquid is minimally ionized at least in the vicinity of said resist film out of a region where said liquid is provided;
performing pattern exposure by selectively irradiating said resist film with said exposing light with said liquid provided on said resist film in said atmosphere; and
forming a resist pattern by developing said resist film after the pattern exposure.

11. The pattern formation method of Claim 10,
wherein the step of obtaining an atmosphere in which said liquid is minimally ionized includes a sub-step of supplying an inert gas to above said resist film.

12. The pattern formation method of Claim 11,
wherein said inert gas includes at least one of nitrogen, argon and neon.

13. The pattern formation method of Claim 10,
wherein the step of obtaining an atmosphere in which said liquid is minimally ionized includes a sub-step of providing an atmosphere of an inert gas above said resist film.

14. The pattern formation method of Claim 13,
wherein said inert gas includes at least one of nitrogen, argon and neon.

15. The pattern formation method of Claim 10,
wherein the step of obtaining an atmosphere in which said liquid is minimally ionized includes a sub-step of allowing an inert gas to flow above said resist film.

16. The pattern formation method of Claim 15,
wherein said inert gas includes at least one of nitrogen, argon and neon.

17. The pattern formation method of Claim 10,
wherein the step of obtaining an atmosphere in which said liquid is minimally ionized includes a sub-step of removing a carbon dioxide gas from an atmosphere above said resist film.

18. The pattern formation method of Claim 17,
wherein hydrotalcite is used in the sub-step of removing a carbon dioxide gas.

19. The pattern formation method of Claim 10,
wherein said liquid is water or perfluoropolyether.

20. The pattern formation method of Claim 10,
wherein said exposing light is KrF excimer laser, ArF excimer laser, F₂ laser, Kr₂ laser, ArKr laser, Ar₂ laser or Xe₂ laser.

21. A pattern formation method comprising the steps of:
forming a resist film on a substrate;
providing, onto said resist film, a liquid having been prevented from being ionized;
performing pattern exposure by selectively irradiating said resist film with exposing light with said liquid having been prevented from being ionized provided on said resist film; and
forming a resist pattern by developing said resist film after the pattern exposure.

22. The pattern formation method of Claim 21,
wherein the step of providing a liquid having been prevented from being ionized includes a sub-step of changing said liquid into ultrapure water.

23. The pattern formation method of Claim 21,
wherein said liquid having been prevented from being ionized has conductivity of 0.03 µS/cm or less.

24. The pattern formation method of Claim 21,
wherein said liquid is water.

25. The pattern formation method of Claim 21,
wherein said exposing light is KrF excimer laser, ArF excimer laser, F₂ laser, Kr₂ laser, ArKr laser, Ar₂ laser or Xe₂ laser.
